# EUROPÄISCHE PATENTANMELDUNG

(11) **EP 1 128 389 A1**
(43) Veröffentlichungstag der Anmeldung: **29.08.2001**
(21) Anmeldenummer: 01104929.3
(22) Anmeldetag: 28.02.2001
(51) Int. Cl.: G11C 11/4091

(54) **Schreib-/Leseverstärker mit Vertikaltransistoren für DRAM-Speicher**

(30) Priorität: 28.02.2000 DE 10009346
(71) Anmelder: Infineon Technologies AG, 81669 München (DE)
(72) Erfinder: Frey, Alexander, 81753 München (DE); Schloesser, Till, Dr., 01109 Dresden (DE); Weber, Werner, Dr., 80637 München (DE)
(74) Vertreter: Reinhard - Skuhra - Weise & Partner

(57) **Zusammenfassung**

Als Konsequenz der Verkleinerung der DRAM-Speicherzelle verringert sich der zur Verfügung stehende Platz für Schreib/Leseverstärker in der Breite von bislang 4 Bitlinerastern auf zwei Bitlineraster. Konventionell vorbekannte Schreib/Leseverstärker können auf diesem reduzierten, noch zur Verfügung stehenden Platz nicht untergebracht werden. Daher war es bislang nicht möglich, nebeneinander angeordnete Schreib/Leseverstärker bereitzustellen, die mit den neuartigen DRAM-Speicherzellen-Abständen auskommen würden. Das der Erfindung zugrundeliegende Prinzip basiert darauf, zumindest einen Teil der üblicherweise für Schreib-/Leseschaltungen verwendeten Transistoren konventioneller Bauart durch sogenannte Vertikaltransistoren zu ersetzen, bei denen die verschieden dotierten Bereiche übereinander oder praktisch übereinander angeordnet sind. Die Verwendung von Vertikaltransistoren spart gegenüber der Verwendung herkömmlicher Transistoren genügend Raum, um eine Anordnung einer Schreib-/Leseschaltung im Raster auch bei einer verminderten Rasterbreite zu gewährleisten.

## Beschreibung

Die vorliegende Erfindung betrifft Schreib-/Leseverstärker für DRAM Speicher, die mit Vertikaltransistoren ausgeführt sind.

Dynamic Random Access Memories (DRAM-Speicher) stellen den wichtigsten Speichertyp zur Speicherung digitaler Informationen dar. Jede DRAM-Speicherzelle besteht aus einem Transistor zur Ansteuerung der Zelle und einer Kapazität zur Speicherung einer Ladung, welche die in der Speicherzelle gespeicherte Information repräsentiert.

Die Speicherzellen sind in matrizenförmigen Anordnungen geschaltet. Zu jeder Speicherzelle führt eine sogenannte Wordline und eine Bitline, wobei alle Speicherzellen einer Reihe mit derselben Wordline, beziehungsweise mit zwei Wordlines, welche jeweils mit jeder zweiten Zelle verbunden sind und jede der Zeilen der Matrix von Speicherzellen mit einer oder zwei Bitlines verbunden sind. Durch Aktivieren einer bestimmten Wordline lassen sich alle damit verbundenen Speicherzellen über ihre Bitlines auslesen, beschreiben oder bezüglich ihres Informationsinhalts auffrischen (refreshen). Das Auffrischen ist bei DRAM Speicherzellen notwendig, da auf Grund von Leckströmen, speziell bei integrierten Bausteinen, die in der Kapazität gespeicherte Ladung im Laufe der Zeit verlorengeht.

Zum Auslesen der in Speicherzellen enthaltenen Informationen, beziehungsweise zum Refreshen der Informationen, werden sogenannte Schreib-/Leseschaltungen verwendetet, welche jeweils mit üblicherweise zwei Bitlines verbunden sind. Die Kopplung mit zwei Bitlines ermöglicht einen Vergleich der Ladungsunterschiede und vereinfacht damit die Bewertung eines Speicherzelleninhalts.

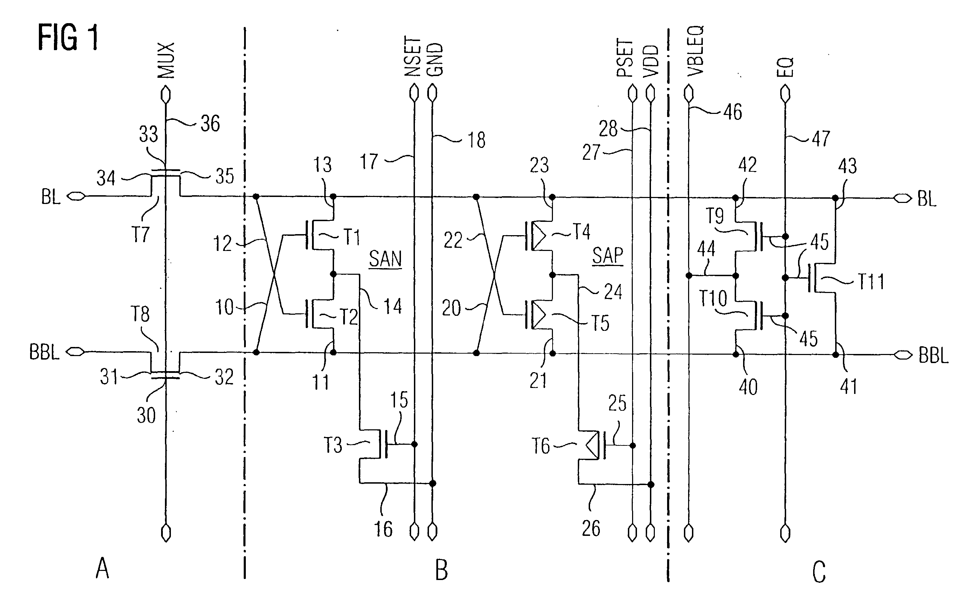

Figur 1 zeigt ein Beispiel einer solchen, im Stand der Technik bekannten, Schreib-/Lesevorrichtung zum Auslesen von DRAM-Speicherzellen. Diese Schaltung besteht im wesentlichen aus einem Multiplexerteil A, einem Auswertungsteil B und einem Precharge/Equalize-Teil C. Den Kern der Schaltung bildet der Auswerteteil B mit einem FlipFlop, der aus zwei Transistorpaaren mit den gleichpoligen Transistoren besteht, nämlich den nMOS-Transistoren T1 und T2, beziehungsweise den pMOS-Transistoren T4 und T5. Im vorliegenden Beispiel wird der Schreib-/Leseverstärker mit zwei Bitlines, der Bitline BL und der Referenz-Bitline BBL verbunden. Hierbei ist BBL über den Anschluß 10 mit dem Gate des Transistors T1 verbunden, während BL über den Anschluß 12 mit dem Gate des Transistors T2 verbunden ist. Ferner ist BBL über Anschluß 11 mit einem der Source/Drain-Bereiche des Transistors T2 und BL über den Anschluß 13 mit einem Source/Drain-Bereich des Transistors T1 verbunden. Der andere Source/Drain-Bereich beider Transistoren ist über den SAN-Anschluß 14 mit Transistor T3 verbunden, welcher über Anschluß 15 mittels des Signals NSET über die Signalleitung, beziehungsweise Leiterbahn 17, geschaltet werden kann, um auf Ground (GND) gezogen werden zu können. Dies geschieht über die Groundleitung 18 und den Anschluß 16, der am anderen Source/Drain-Bereich des Transistors T3 anliegt. Das zweite Transistorpaar, bestehend aus den Transistoren T4 und T5, ist in gleicher Weise mit den Bitlines BL und BBL verschaltet, wobei jedoch an dem Transistor T6 nicht Ground sondern VDD angelegt werden kann. Diese Schaltungsanordnung bewirkt eine Segregation der möglichen Signalzustände zu eindeutigen Signalpegeln, welche eine Bewertung des Zelleninhalts bezüglich logisch 1 oder logisch 0 erlaubt.

Der Multiplexerteil A besteht aus den beiden Transistoren T7 für die Bitline BL und T8 für die Bitline BBL. Die Bitline BL wird hierbei über Anschluß 34 an einen Source/Drain-Bereich des Transistors T7 angeschlossen, während die Bitline BBL über Anschluß 31 an den Transistor T8 angeschlossen ist. Über die MUX-Leitung 36 kann ein Multiplexersignal den Anschlüssen 33 und 30 der Transistoren T7 und T8 zugeführt werden, so daß diese einschalten. Beim Einschalten wird die an BL, beziehungsweise BBL liegende Spannung über die Anschlüsse 35 und 32 weitergegeben.

Der Precharge/Equalizerteil C schließlich besteht aus den drei Transistoren T9, T10 und T11. Während BBL über einen Anschluß 40 an einem Source/Drain-Bereich des Transistors T10 anliegt, ist BL über Anschluß 42 mit einem Source/Drain-Bereich des Transistors T9 verbunden. Die jeweils anderen Source/Drain-Bereiche der beiden Transistoren T9 und T10 sind über Anschluß 44 mit der VBLEQ-Signalleitung 46 verbunden. Der Transistor T11 ist über Anschluß 41 mit BBL und über Anschluß 43 mit BL in seinem Source/Drain-Bereich mit beiden Bitlines gleichzeitig verbunden. Alle drei Gate-Bereiche der Transistoren T9, T10 und T11 werden über den Anschluß 45 mit der EQ-Leitung 47 verbunden. Die hier beschriebene Schaltung für eine Schreib-/Leseschaltung ist als exemplarisch anzusehen. Sie soll nicht die Erfindung beschränken und kann zahlreiche Variationen erfahren.

DRAM-Speicherbausteine unterliegen einem starken Kostendruck. Heutige DRAM-Speicher werden praktisch ausschließlich als integrierte Halbleiter realisiert, bei denen die Anordnungen von Speicherzellen, Wordline inklusive Worlineansteuerung, Bitline inklusive der Bitline-Ansteuerung etc. auf einem integrierten Schaltkreis direkt als Strukturen eines Siliziumwafers abgebildet werden. Der Hauptfaktor bei den Kosten der Herstellung von integrierten Schaltkreisen ist die Größe der jeweils verwendeten Siliziumoberfläche. Daher bestehen bei dem existierenden Kostendruck große Bestrebungen, die Chipfläche für eine bestimmte Anzahl von Speicherzellen, inklusive ihrer Support-Logik, möglichst klein zu gestalten. Eine fortwährende Verkleinerung ist aus Kostendruckgründen praktisch permanent notwendig. Hierzu wird auch die inhärente Architektur der DRAM-Speicherzelle permanent optimiert. Die Architektur einer solchen DRAM Speicherzelle ermöglicht ab der 1 Gbit-Generation einen Flächenverbrauch unter 8 F², wobei F die minimale lithographisch erzeugbare Strukturgröße bzw, eine halbe Rasterbreite einer Bitline in einer Abfolge von parallelen Bitlines darstellt. Als Konsequenz dieser Verkleinerung der Fläche ergibt sich für die Bitline-Architektur der Übergang von einem "folded" Konzept, bei dem typischerweise zwei Wordlines nebeneinander hergeführt werden, die jeweils jede zweite Zelle ansprechen, zum sogenannten "open" Konzept, bei dem lediglich noch eine Wordline Verwendung findet, mit der jede Zelle einer Reihe ansprechbar ist. Ein Vergleich der Ladungsmengen von zwei benachbarten Bitlines ist auf diese Weise zunächst einmal nicht möglich. Daher kann eine parallele Referenz-Bitline nicht als Referenz verwendet werden. Statt dessen wird eine Referenz-Bitline zu einem anderen Zellenfeld geführt, um weiterhin einen Vergleich der Spannungen einer angesprochenen Bitline und einer nicht angesprochenen, Referenz-Bitline durchführen zu können. Durch den Wegfall der zweiten, parallelen Bitline verkleinert sich die zur Verfügung stehende Breite für den Schreib-/Leseverstärker. Als Konsequenz der Verkleinerung der DRAM-Speicherzelle verringert sich bei konventioneller Wordline- und Bitline- Anordnung der zur Verfügung stehende Platz für den Schreib/Leseverstärker in der Breite von bislang 8 F auf 4 F. Bei einer weiteren Ausführungsform werden zwei Bitlines übereinander angeordnet, die zu unterschiedlichen, beispielsweise in Streifen nebeneinanderliegenden Zellenfeldern führen.

Konventionell vorbekannte Schreib-/Leseverstärker können auf diesem reduzierten, noch zur Verfügung stehenden Platz nicht untergebracht werden. Daher war es bislang nicht möglich, nebeneinander angeordnete Schreib-/Leseverstärker bereitzustellen, die mit den neuartigen DRAM-Speicherzellen-Abständen auskommen würden. Statt dessen war es notwendig, die Anordr.ung der Schreib-/Leseschaltungen auf dem Chip den Gegebenheiten der verringerten Zellengröße anzupassen. Solche Anordnungen erhöhen jedoch wiederum den Flächenbedarf der unterzubringenden Schreibe-/Leseschaltungen und beeinträchtigen damit in negativer Weise die Gesamtkosten jedes einzelnen DRAM Speicherbausteins.

Der Erfindung liegt somit die Aufgabe zugrunde, eine Schreib/Leseschaltung bereitzustellen, welche sich in das verringerte Raster mit einer Breite von lediglich 4 F moderner DRAM-Speicherbausteine einzufügen vermag.

Diese Aufgabe wird gelöst durch die Bereitstellung einer integrierten Schreib-/Leseschaltung in einem DRAM-Speicher gemäß dem unabhängigen Patentanspruch 1 und der Verwendung von Vertikaltransistoren für die Schreib-/Leseschaltung eines integrierten DRAM-Speichers gemäß dem unabhängigen Patentanspruch X.

Weitere vorteilhafte Ausgestaltung, Aspekte und Details der Erfindung ergeben sich aus den abhängigen Patentansprüchen, der Beschreibung und den beigefügten Zeichnungen.

Das der Erfindung zugrundeliegende Prinzip basiert darauf, zumindest einen Teil der üblicherweise für Schreib-/Leseschaltungen verwendeten Transistoren konventioneller Bauart durch sogenannte Vertikaltransistoren zu ersetzen, bei denen die verschieden dotierten Bereiche übereinander oder praktisch übereinander angeordnet sind. Die Verwendung von Vertikaltransistoren spart gegenüber der Verwendung herkömmlicher Transistoren genügend Raum, um eine Anordnung einer Schreib/Leseschaltung im Raster auch bei einer verminderten Rasterbreite zu gewährleisten.

Demgemäß ist die Erfindung gerichtet auf eine integrierte Schreib-/Leseschaltung zur Auswertung von zumindest einer Bitline in einem DRAM-Speicher, welche dadurch gekennzeichnet ist, daß zumindest ein in der Schreib-/Leseschaltung verwendete Transistor ein Vertikaltransistor ist.

Die Schreib-/Leseschaltung kann wie üblich zumindest zwei Transistorpaare verschiedenen Kanaltyps zur Auswertung aufweisen, wobei die für die Transistorpaare der Schreib-/Leseschaltung verwendeten Transistoren Vertikaltransistoren sein können. Da die Transistorpaare üblicherweise den Kern einer Schreib-/Leseschaltung bilden, kann auf diese Weise ein hinreichend kleiner Raum bedeckt werden, um die erfindungsgemäße Aufgabe lösen zu können.

Um eine besonders platzsparende Anordnung der Vertikaltransistoren innerhalb eines Transistorpaars zu ermöglichen, kann es weiterhin bevorzugt werden, daß diese einen gemeinsamen Source/Drain-Bereich aufweisen, über den sie mit der jeweils nötigen Spannung (SAN-, SAP-Eingänge) versorgt werden können. Da jeweils einer der Source/Drain-Bereiche der Transistoren jedes Transistorpaars auf einem gemeinsamen Potential liegen, bietet sich diese Lösung an, um eine weitere Vereinfachung der auf dem Chip notwendigen Siliziumbereiche zu erzielen.

Auch zum Aufschalten der für den Betrieb der Transistorpaare notwendigen Spannungen (VDD, GND) auf die Transistorpaare werden Transistoren verwendet. Erfindungsgemäß können auch diese Transistoren Vertikaltransistoren sein.

Eine noch weitergehende Vereinfachung der Schaltung läßt sich dadurch erzielen, daß sowohl die Vertikaltransistoren eines beliebigen Transistorpaars als auch der zur Aufschaltung der Spannung für dieses Transistorpaar verwendete Vertikaltransistor einen gemeinsamen Source/Drain-Bereich aufweisen.

Wie Figur 1 zeigt, sind die Source/Drain-Bereiche der Transistorpaare mit den zugehörigen Schalttransistoren ohnedies verknüpft, so daß sich die Anlage einer gemeinsamen Source/Drain-Wanne anbietet. Der gemeinsame Source/Drain-Bereich der Vertikaltransistoren kann mit einer Spannungsquelle (VDD oder GND) über eine SET-Leitung, also je nach Typ des Transistors, eine NSET oder eine PSET-Leitung, verbunden sein.

Um die angestrebte Raumersparnis erreichen zu können, wird es bevorzugt, daß die für die Transistorpaare verwendeten Vertikaltransistoren eine solche Breite in Querrichtung zu der zumindest einen Bitline aufweisen, daß sie in etwa der Rasterbreite der Bitlines entspricht. Die Rasterbreite einer Bitline ist dabei die Ausdehnung, welche die Breite einer Bitline inklusive des notwendigen Abstands zur nächsten Bitline umfasst. Auf diese Weise läßt sich gewährleisten, daß die für jedes Transistorpaar notwendigen zwei Transistoren nebeneinander angeordnet werden können, was beispielsweise die Verwendung gemeinsamer Source/Drain-Bereiche vereinfacht.

Die erfindungsgemäße Schreib-/Leseschaltung weist weiterhin vorzugsweise eine Multiplexer-Schaltung zum Schalten der zumindest einen Bitline auf, wobei die für die Multiplexer-Schaltung verwendeten Transistoren Vertikaltransistoren sind. Durch die Realisierung weiterer Baugruppen der Schreib-/Leseschaltung mit Hilfe von Vertikaltransistoren können weitere Engpässe im Layout beseitigt werden. Auch die Multiplexer-Schaltung läßt sich sinnvoll so auslegen, daß sie in das vorgegebene Raster hineinpaßt.

Zur weiteren Platzersparnis kann zumindest ein Teil der Vertikaltransistoren zur Schaltung aller Bitlines einen gemeinsamen Polysilizium-Gate-Bereich aufweisen. Unter "allen" Bitlines sind hierbei alle Bitlines zu verstehen, die einer bestimmten Schreib-/Leseschaltung zugeordnet sind, nicht hingegen alle Bitlines, die überhaupt im DRAM-Speicher vorhanden sind.

Der gemeinsame Polysilizium-Gate-Bereich der Vertikaltransistoren kann weiterhin vorzugsweise mit einer Multiplexer-Signalquelle verbunden sein, um über die Gate-Bereiche die Transistoren schalten zu können.

Schließlich kann die erfindungsgemäße Schreib-/Leseschaltung auch einen Precharge/Equalize-Teil aufweisen, wobei die für die Precharge/Equalize-Schaltung verwendeten Transistoren Vertikaltransistoren sein können.

Somit ist es möglich, daß alle drei Teilschaltungen der gesamten erfindungsgemäßen Schreib-/Leseschaltung mit Vertikaltransistoren zumindest in Teilen bestückt sind. Besonders bevorzugt wird es, wenn die gesamte Schreib-/Leseschaltung in allen ihren Teilen mit Vertikaltransistoren ausgestattet ist, um das vorgegebene schmale Raster moderner DRAM-Speicher einhalten zu können.

Vorzugsweise weist zumindest ein Teil der Vertikaltransistoren der Precharge/Equalize-Schaltung einen gemeinsamen Polysilizium-Gate-Bereich auf. Auch hier findet sich wieder das grundlegende Prinzip, verbindbare Bereiche verschiedener Transistoren durch gemeinsame Strukturen im Silizium abzubilden, um die Gesamtstruktur einfach zu halten und den räumlichen Bedarf zu verringern.

Der gemeinsame Polysilizium-Gate-Bereich der Vertikaltransistoren der Precharge/Equalize-Schaltung ist vorzugsweise mit einer Equalize-Signal-Quelle (EQ) verbunden.

Weiterhin kann die Precharge/Equalize-Schaltung für jede der zumindest einen Bitline einen Transistor aufweisen, welcher an einem Source/Drain-Bereich mit einer Spannungsquelle verbunden ist, wobei diese Source/Drain-Bereiche der Transistoren einen gemeinsamen Source/Drain-Bereich bilden.

Von ihrem Aufbau her weisen die Vertikaltransistoren vorzugsweise einen Vorsprung auf dem Substratmaterial auf, dessen Seitenwände als Kanal fungieren, eine auf den Vorsprung angeordnete Schicht aus Material mit einer zum Substrat inversen Dotierung als ersten Source/Drain-Bereich, eine auf dem Substrat neben dem Vorsprung angeordnete Schicht aus Material mit einer zum Substrat inversen Dotierung als zweiten Source/Drain-Bereich und einen an den Seitenwänden des Vorsprungs und am Übergang von den Seitenwänden des Vorsprungs zum zweiten Source/Drain-Bereich angeordneten Gatebereich aus Polysilizium auf. Das Polysilizium kann weiterhin einen Polysiliziumkontaktbereich bilden, um den Gatebereich kontaktieren zu können.

Durch diese bevorzugte Anordnung eines Vertikaltransistors läßt sich eine sehr starke Platzersparnis gegenüber der Verwendung konventioneller, horizontal angeordneter Transistoren erzielen. Der Vorsprung kann beispielsweise so ausgebildet sein, daß er bei den Transistoren der Transistorpaare eine Breite aufweist, die es erlaubt, ihn in das Breitenraster der Bitlines einzufügen, d.h., daß eine Breite, welche etwa einer halben Rasterbreite der Bitline entspricht (da auch die Zwischenräume realisiert werden müssen). Hier kann man also bei der Ausbildung von Strukturen an das lithographische Minimum herangehen. Andere Transistoren können einen Vorsprung aufweisen, dessen Breite etwa der Rasterbreite einer Bitline entspricht, so daß sie die gesamte Rasterbreite bis zur nächsten Bitline einnehmen und in zwei Raterbreiten hineinpassen. Dies kann dann bevorzugt sein, wenn nicht zwei nebeneinander liegende Transistoren für jede Bitline oder Bitline-Gruppe vorgesehen sein müssen, sondern lediglich einer, dieser aber möglicherweise von zwei Bitlines bedient werden muß.

Die erfindungsgemäße Schreib-/Leseschaltung ist insbesondere dadurch bevorzugterweise gekennzeichnet, daß sie mit zwei Bitlines verbunden ist. Eine Anordnung mit zwei Bitlines entspricht dem bisherigen Vorgehen bei der Auslegung von Schreib-/Lesevorrichtungen und vereinfacht die Anwendung der Transistorpaare, da diese von den beiden Bitlines gespeist werden können. Die Bitlines können zu verschiedenen Speicherseiten des DRAM-Speichers führen. Es kann allerdings bevorzugt sein, die zwei Bitlines zu einer Speicherseite führen zu lassen. In diesem Fall bietet es sich an, die zwei Bitlines oberhalb der Schreib-/Leseschaltung und bezüglich der Hauptebene des DRAM-Speichers übereinander anzuordnen. Die Verbindung der Bitlines mit den Vertikaltransistoren kann dann vorzugsweise über im wesentlichen vertikale Leiterbahnen, die von den Bitlines hinunter bis auf die Transistoren reichen, erfolgen.

Die Erfindung ist weiterhin gerichtet auf die Verwendung von Vertikaltransistoren für die Schreib/-Leseschaltungen eines integrierten DRAM-Speichers. Bezüglich der Vorteile dieser erfindungsgemäßen Verwendung wird auf die Ausführungen bezüglich der erfindungsgemäßen Schreib-/Leseschaltung verwiesen, und auf diese wird vollinhaltlich Bezug genommen.

Im folgenden soll die Erfindung an Hand von konkreten Ausführungsbeispielen näher erläutert werden, wobei auf die beigefügten Zeichnungen Bezug genommen werden soll, in denen folgendes dargestellt ist:
Figur 1 zeigt, wie oben beschrieben, eine übliche Schreib/Leseschaltung zur Auswertung von Bitlines in einem DRAM-Speicher;
Figur 2 zeigt einen Auswerteteil einer erfindungsgemäßen Schreib-/Leseschaltung in einer bevorzugten Ausführungsform der vorliegenden Erfindung;
Figuren 3 und 4 zeigen Querschnitte durch die in Figur 2 in Aufsicht gezeigte integrierte Schaltung längs der Schnittlinien III und IV;
Figur 5 zeigt in dreidimensionaler Darstellung die Verbindung von zwei Bitlines mit einem Transistorpaar gemäß einer bevorzugten Ausführungsform der vorliegenden Erfindung;
Figur 6 zeigt in Aufsicht eine Multiplexerschaltung gemäß einer bevorzugten Ausführungsform der vorliegenden Erfindung;
Figur 7 zeigt einen Querschnitt durch einen Vertikaltransistor in einer Multiplexerschaltung längs der Schnittlinie VII von Figur 6;
Figur 8 zeigt längs der Schnittlinien VIIIa bis VIIId der Figur 6 im Querschnitt die Anordnung der beiden vertikal übereinander verlaufenden Bitlines in der Multiplexerschaltung; Figur 9 zeigt in Aufsicht eine Precharge/Equalize-Schaltung gemäß einer bevorzugten Ausführungsform der vorliegenden Erfindung; und
Figur 10 zeigt im Querschnitt die Transistoren der Precharge/Equalize-Schaltung längs der Schnittlinie X von Figur 9.

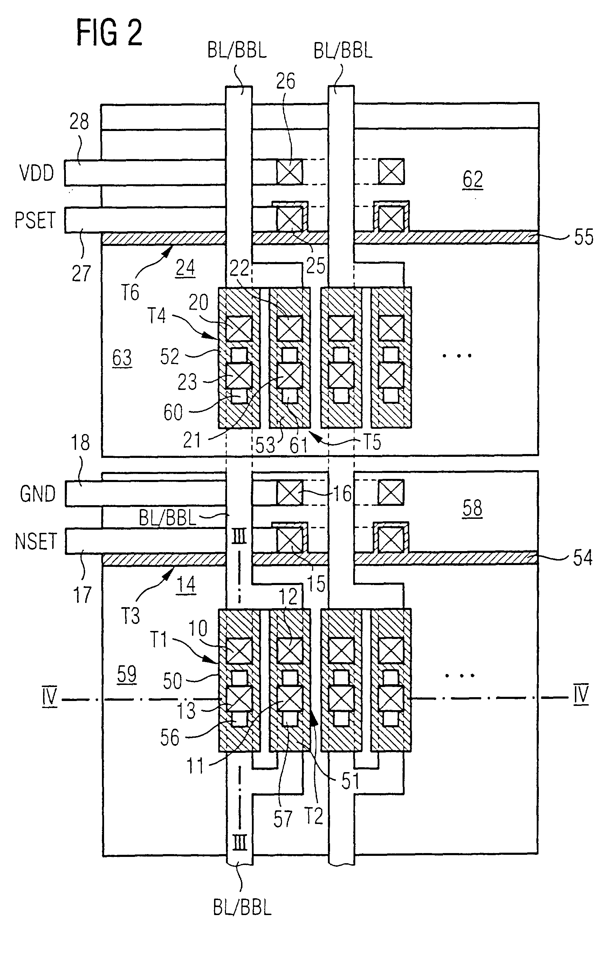

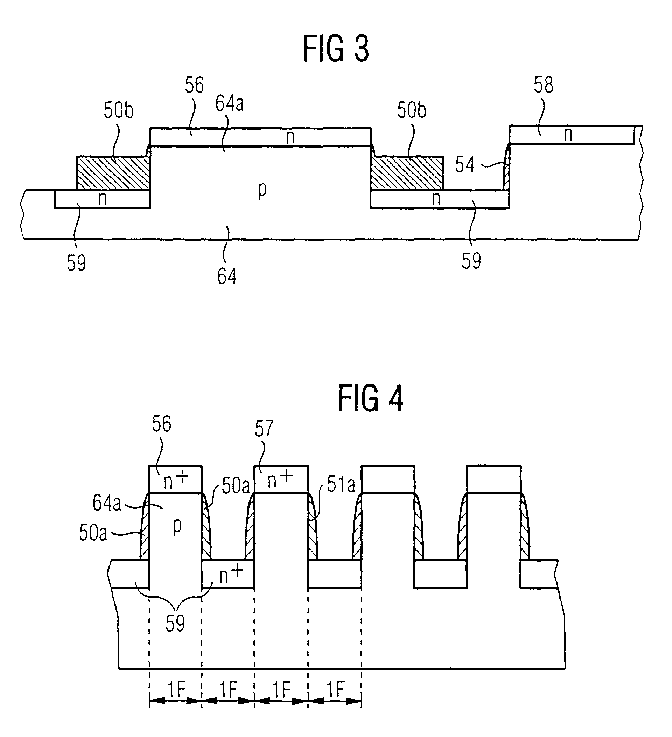

In Figur 2 wird die Auswerteschaltung und damit der Kern der erfindungsgemäßen Schreib-/Leseschaltung gezeigt. Die Zeichnung zeigt in Aufsicht zwei verschiedene Bereiche von Transistorpaaren, die sich in der internen Anordnung ihrer Transistoren und damit auch in der Dotierung der verschiedenen Schichten unterscheiden. Die in Figur 2 gezeigte Anordnung von Siliziumbereichen ergibt eine Schaltung, die der Auswerteschaltung B der Figur 1 entspricht. Daher werden gleiche Strukturen mit gleichen Bezugszeichen versehen. Aus dem oberen Bereich der Figur kommen zwei vertikal übereinander angeordnete Bitlines BL und BBL, welche über die Transistoren T1 und T4 und parallel zur Ebene des DRAM-Speichers geführt werden. Von den Bitlines zweigen die vertikal nach unten reichenden Anschlüsse ab. Figur 2 zeigt jeweils die Polysiliziumbereiche der Transistoren T1 bis T4 und T3 sowie T6 durch schraffierte Flächen. Die nicht schraffierten Bereiche 56 bei T1, 57 bei T2, 60 bei T4 und 61 bei T5 sind n-(56, 57)-dotierte, beziehungsweise p-(60, 61)-dotierte Bereiche der Transistoren, die als Source/Drain-Bereiche dienen. Die Source/Drain-Bereiche und die sie umgebenden Polysiliziumbereiche sind insgesamt eingebettet in flächige n-dotierte Schichten von T1, T2 und T3 (59), beziehungsweise p-dotierte gemeinsame Schichten von T4, T5 und T6 (63). Der dreidimensionale Aufbau dieser verschiedenen Siliziumbereiche wird weiter durch die Figuren 3 und 4 verdeutlicht, wobei Figur 3 einen Querschnitt in Richtung der Bitlines darstellt, während in Figur 4 ein Querschnitt in Querrichtung zu den Bitlines dargestellt wird. Wie ersichtlich, liegt das Substrat 64, welches bei den Transistoren T1 und T2 eine p-Dotierung aufweist, unter den anderen verwendeten Strukturelementen. Aus dem Substrat 64 ragen Substrat-Vorsprünge 64a hervor, welche maßgeblich die vertikale Anordnung der erfindungsgemäß verwendeten Transistoren gewährleisten. Auf dem Vorsprung ist eine invers dotierte Schicht 56 (in Figur 3 n-dotiert) angeordnet, welche als Source/Drain-Bereich des dargestellten Transistors dient. Der Vorsprung ist auf allen Seiten von Polysilizium 50 umgeben. Zwischen dem Polysilizium-Gate-Bereich 50a und dem Substratvorsprung 64a, beziehungsweise der Schicht 56, befindet sich des weiteren eine Oxidschicht, die vorliegend nicht dargestellt ist. Wie aus Fig. 3 ersichtlich, gehen die Polysilizium-Gate-Bereiche 50a in Polysiliziumkontaktbereiche 50b über, welche der Kontaktierung mit den Bitlines dienen. Der Aufbau der anderen Transistoren T2, T4 und T5 entspricht, teils bis auf die Dotierung, dem Aufbau des in Figur 3 gezeigten Transistors T1.

Die Figuren 2 und 3 zeigen weiterhin vertikal angeordnete Transistoren T3 und T6, welche der Aufschaltung der Spannung VDD, beziehungsweise Ground GND, auf die Vertikaltransistoren dient. Die benötigten Spannungen werden über Leiterbahnen 18 für GND, beziehungsweise 28 für VDD, erreicht, welche mit Kontakten 16 beziehungsweise 26 an einem Source/Drain-Bereich 58 beziehungsweise 62 der Transistoren T3 beziehungsweise T6 anliegen. Die Transistoren T3 und T6 werden vermittels ihrer Polysilizium-Gate-Bereiche 54 beziehungsweise 55, die ebenfalls vertikal einem Vorsprung anliegen, über Anschlüsse 15 und 25 sowie Leiterbahnen 17 und 27 mit den Signalen NSET beziehungsweise PSET ein- und ausgeschaltet. Hierdurch können in einfacher Weise die SAN- und SAP-Anschlüsse 14 beziehungsweise 24 der Schaltung der Figur 1 realisiert werden. Wie in Figur 1 bereits dargestellt, dienen die Anschlüsse 10, 12, 20 und 22 der Verbindung der Bitlines mit den Gate-Bereichen der Transistoren T1, T2, T4 und T5. Desgleichen dienen die Anschlüsse 11, 13, 21 und 23 der Verbindung der Bitlines mit den ersten Source/Drain-Bereichen der Transistoren T1, T2, T4 und T5.

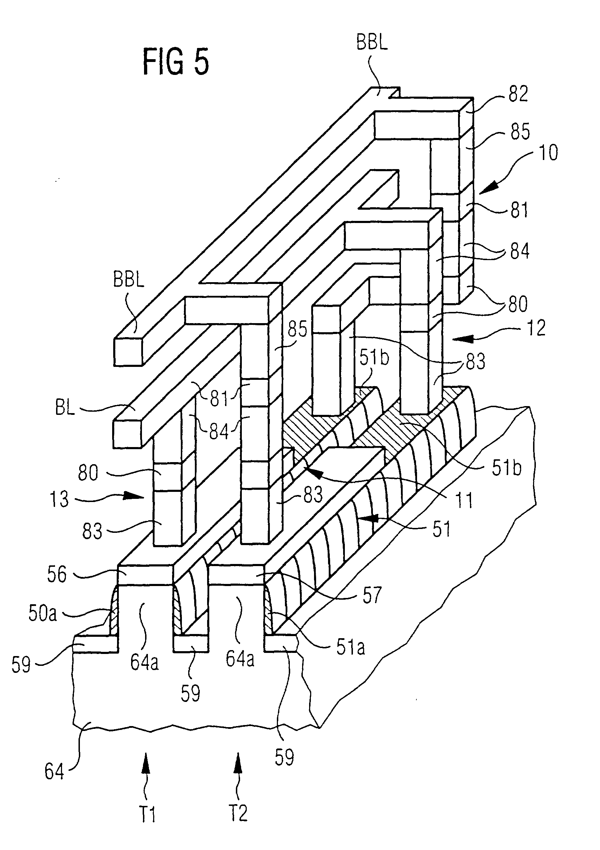

Die konkrete Ausgestaltung der von den Bitlines zu den Transistoren reichenden Anschlüsse ist in der dreidimensionalen Darstellung der Figur 5 beispielhaft für das Transistorpaar T1/T2 gezeigt. Auch hier kennzeichnen identische Bezugszeichen gleiche Merkmale. Die Figur zeigt, wie die Polysiliziumbereiche 50 und 51 um die Substratvorsprünge 64a und die Schichten 56, 57 herumreichen und im hinteren Bereich der Darstellung einen eigenen Block 50b, 51b mit einer Oberfläche bilden, an der die Anschlüsse 10, 12 angebracht werden können. Die Anschlüsse 11 und 13 sind auf den Schichten 57 beziehungsweise 56 angeordnet. Die Figur 5 zeigt klar den Aufbau der erfindungsgemäß verwendeten Vertikaltransistoren aus einer Schicht 56, 57 einer vorgegebenen Dotierung, einem aus dem invers dotierten Substrat 64 bestehenden Vorsprung 64a, auf dem die Schichten 56 und 57 aufgelagert sind, einer in den Gruben zwischen den Vorsprüngen und seitlich der Vorsprünge angeordnete Schicht 59, wiederum der ersten Orientierung, sowie ein den Vorsprung und partiell gegebenenfalls die Schichten 56 und 57 umgebender Polysiliziumbereich 50 bzw. 51.

Figur 5 zeigt weiterhin die beiden übereinander angeordneten Bitlines BL und BBL sowie die von diesen teils horizontal und dann vertikal abknickend, teils unmittelbar vertikal abgehenden Anschlußsäulen 10, 11, 12 und 13.

Der Aufbau der Anschlüsse und der Bitlines erfolgt in einem mehrstufigen Verfahren, das sich in verschiedene Metallisierungsebenen niederschlägt. Zunächst sind zu erkennen die drei Metallisierungsebenen 80, 81 und 82, welche einer horizontalen Ausbreitung des jeweils verwendeten Materials, beispielsweise Wolfram dienen und aus denen auch die eigentlichen Bitlines bestehen. In Bereichen ohne Metall bestehen die Metallisierungsebenen aus einem Isolationsmaterial, beispielsweise einem Oxid. Zwischen den drei Hauptmetallisierungsebenen sind Isolationsschichten, beispielsweise Oxidschichten angeordnet. Um eine Durchkontaktierung der Anschlüsse bis zur Transistorebene zu gewährleisten, sind in diesen Isolationsschichten sogenannte Kontaktlöcher vorgesehen, welche ebenfalls mit Metall ausgefüllt sind. Dies ist in der Figur gekennzeichnet bezüglich einer ersten Isolationsschicht mit dem Bezugszeichen 83, bezüglich einer zweiten Isolationsschicht mit dem Bezugszeichen 84 und schließlich bezüglich einer dritten Isolationsschicht mit dem Bezugszeichen 85.

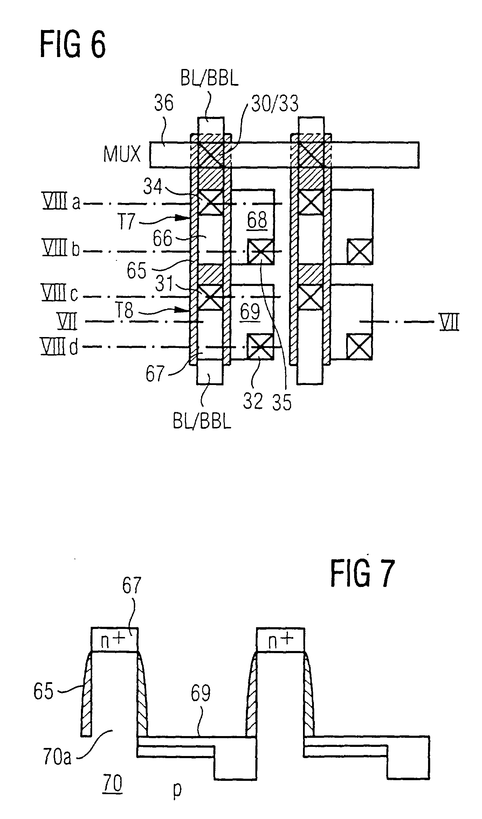

Figur 6 zeigt in Aufsicht das mögliche Silizium-Layout einer Multiplexer-Schaltung der erfindungsgemäßen Schreib-/Leseschaltung. Hierbei weisen die beiden Transistoren T7 und T8 einen gemeinsamen Polysilizium-Gate-Bereich 65 auf, während ihre Source/Drain-Bereiche 66, 67, beziehungsweise 68, 69 voneinander getrennt sind. Die beiden Bitlines BL und BBL sind über die Transistoren hinweggeführt und mit den Kontakten 31 und 32 bei Transistor T8, beziehungsweise 34 und 35 bei Transistor T7 mit diesen in den Source/Drain-Bereichen verbunden. Beide Bitlines sind unterbrochen, wobei die Unterbrechung der Bitline BL sich in etwa über dem Transistor T7 befindet, während die Unterbrechung in der Bitline BBL sich in etwa über dem Transistor T8 befindet. Sofern die Transistoren nicht durch das MUX-Signal über die Signalleitung 36 und den Kontakt 30/33 aktiviert werden, ist somit kein Stromfluß zwischen dem Anschluß 34 und 35 bei Transistor T7, beziehungsweise 31 und 32 bei Transistor T8 möglich und die Bitlines sind unterbrochen.

Figur 7 zeigt einen Querschnitt durch die in Figur 6 gezeigte Schaltungsanordnung längs der Querschnittslinie VII. Auch hier ist wieder deutlich der vertikale Aufbau der Transistoren zu erkennen, welche neben einem Substrat 70, das einen Vorsprung 70a ausbildet, aus einer invers dotierten Schicht 67 über dem Vorsprung und einer ebenfalls invers dotierten Schicht 69 neben dem Vorsprung 70a besteht. Der PolysiliziumBereich 65 ist von Substrat 70 wiederum durch eine nicht dargestellte Oxidschicht abgetrennt.

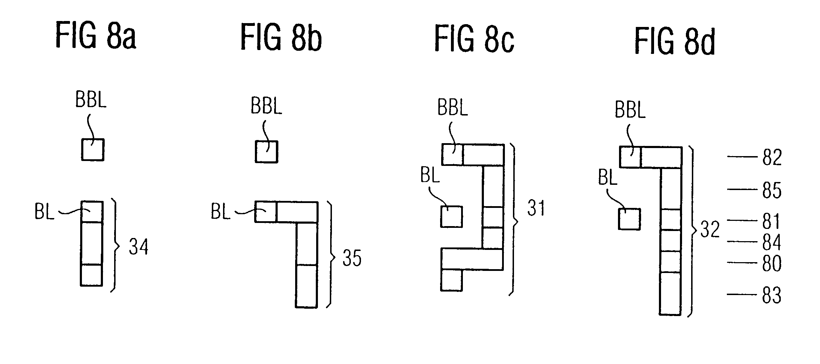

Figur 8 zeigt Querschnitte durch die Bitlines und Anschlußbereiche der in Figur 6 gezeigten Multiplexer-Schaltung längs der Schnittlinien VIIIa bis VIIId. Der Anschluß 34 von der Bitline BL ragt hierbei unmittelbar auf den im vorliegenden Fall n-dotierten Bereich 66 des Transistors T7 herunter. Hinter diesem Anschluß ist die Bitline BL unterbrochen. In Figur 8b ist der andere Anschluß 35 der Bitline BL gezeigt, welcher vom anderen n-dotierten Source/Drain-Bereich des Transistors T7 zur wieder aufgenommenen Bitline BL führt. Die Figuren 8c und 8d zeigen den gleichen Sachverhalt bezüglich der Bitline BBL und der Anschlüsse 31 und 32. Hier zeigt sich insbesondere, daß auf Grund der Mehrzahl der zur Verfügung stehenden Metallisierungsebenen (rechts eingezeichnet) und Kontaktlöcher durch die Isolationsschichten wiederum komplexe Gestaltungen der Anschlüsse möglich sind.

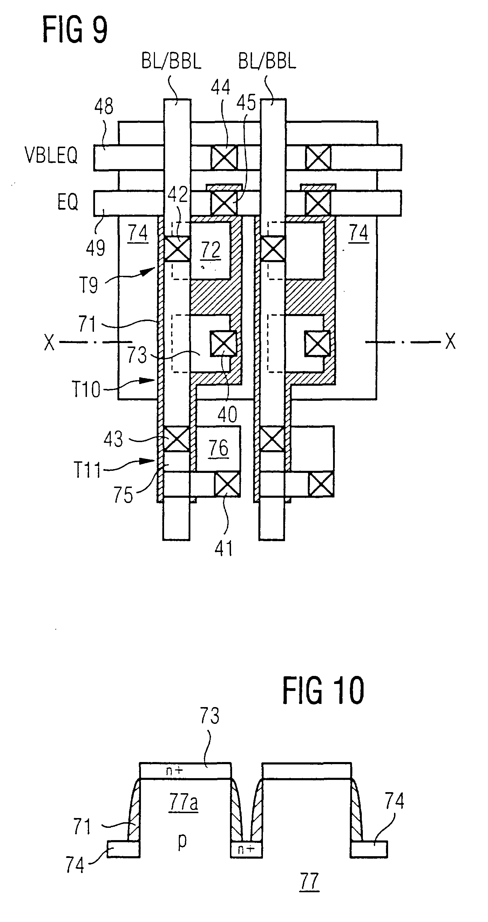

Figur 9 zeigt eine Precharge/Equalize-Schaltung gemäß einer weiteren bevorzugten Ausführungsform der erfindungsgemäßen Schreib-/Leseschaltung. Wie ersichtlich, sind alle drei Transistoren T9, T10 und T11 durch einen gemeinsamen Polysiliziumbereich 71 miteinander und mit der Leiterbahn 49 zur Bereitstellung des Signals EQ über den Anschluß 45 verbunden. Des weiteren weisen die Transistoren T9 und T10 einen gemeinsamen Source/Drain-Bereich 74 auf, welcher über den Anschluß 44 mit der Leiterbahn 48 die Bereitstellung des Signals VBLQ gewährleistet. Die über die Schaltung hinweggeführten Bitlines BL und BBL zweigen nach unten ab. Die Bitline BL ist mit dem Anschluß 42 mit dem zweiten Source/Drain-Bereich 72 des Transistors T9 verbunden, während die Bitline BBL über den Anschluß 40 mit dem zweiten Source/Drain-Bereich 73 des Transistors T10 verbunden ist. Die Bitline BL ist darüber hinaus über Anschluß 43 mit einem Source/Drain-Bereich 75 des Transistors T11 verbunden, während die Bitline BBL über den Anschluß 41 mit dem anderen Source/Drain-Bereich 76 des Transistors T11 verbunden ist.

Figur 10 zeigt wiederum einen Querschnitt längs der Querschnittslinie X der Figur 9 des erfindungsgemäßen Precharge/Equalizers. Wie ersichtlich, sind die Transistoren hier doppelt so breit ausgeführt wie in den anderen Beispielen. Dies ist darauf zurückzuführen, daß auf Grund von lediglich drei verwendeten Transistoren eine hintereinander liegende Anordnung der Transistoren möglich und sinnvoll ist, so daß für jeden der Transistoren das volle Raster (beispielsweise 4F) zur Verfügung steht, und es mit der breiteren Ausführung ebenfalls möglich ist, beide Bitlines ohne Verschlingung der Anschlüsse um die Bitlines herum mit den oberen Source/Drain-Bereichen der erfindungsgemäßen Vertikaltransistoren zu verbinden. Die Transistoren bauen auf einem Vorsprung 77a im Substrat 77 auf.

In den vorangegangenen Zeichnungen sind jeweils zwei Raster und somit auch zwei Bitline-Paare wiedergegeben, um zu verdeutlichen, daß eine Vielzahl von Bitlines nebeneinander angeordnet in DRAM-Speichern vorliegt. Die jeweils zweite Anordnung entspricht in ihrem Aufbau exakt der ersten Anordnung, welche mit Bezugszeichen versehen ist. Durch die Verwendung von jeweils zwei erfindungsgemäßen Schreib-/Leseschaltungen in der Darstellung der Figuren kann zudem gezeigt werden, daß bestimmte Signalleitungen, beziehungsweise bestimmte Elemente der Transistoren (beispielsweise der Polysiliziumbereich 54, 55 oder der Source/Drain-Bereich 59, 63 in Figur 2) tatsächlich von allen Schreib-/Leseschaltungen, die in einem zusammenhängenden Bereich eines DRAM-Speichers angeordnet sind, gemeinsam verwendet werden können.

Um das für moderne DRAM-Speicher benötigte schmalere Raster realisieren zu können, werden folgende mit vertikalen Transistoren möglichen Eigenschaften in der vorliegenden Erfindung ausgenutzt:
- das vertikale Transistorgate verbraucht kaum planare Fläche,
- die Kanallänge ist unabhängig von der verwendeten Lithographie auswählbar,
- die für alle Schreib-/Leseverstärker einer Anordnung identischen Signale, beispielsweise SAN, SAP oder VBLEQ können durchgehend, das heißt ohne Isolation, in einer Ebene in Form eines gemeinsamen Source/Drain-Bereichs ausgeführt werden.

Zudem läßt sich bei konventionellen Speichern die Minimalstrukturgröße F tatsächlich nur im Zellenfeld erzielen, während in der Peripherie, also auch im Bereich von Schreib/Leseverstärkern nur eine Strukturgröße von etwa 1,5 bis 2F zur Verfügung steht. Auf Grund der mit den Vertikaltransistoren erreichbaren hohen Periodizität ist es nunmehr jedoch auch möglich, die minimale Lithographiegröße F auch beim Schreib-/Leseverstärker zu realisieren.

Sofern auch für die Bereitstellung der eigentlichen Zellarchitektur im eigentlichen DRAM-Matrixspeicherbereich vertikale Transistoren eingesetzt werden, kann der technologische Zusatzaufwand für die erfindungsgemäße Schreib-/Leseschaltung gering gehalten werden, da die vertikale Strukturierung, beispielsweise bezüglich Trench, Poly-Spacer-Wordline etc., aus dem Zellenfeld übernommen werden kann.

Die Verwendung vertikaler Strukturen ermöglicht neben einem 4F-Raster ein flächengünstiges Layout in der Längsrichtung des erfindungsgemäßen Schreib-/Lesesverstärkers. So kann durch die oben beschriebene ringförmige, beziehungsweise ummantelnde Ausführung des vertikalen Transistorgates die Kanalweite auf mindestens die doppelte geometrische Weite des Source/Drain-Gebiets vergrößert werden.

Im folgenden soll noch kurz auf die Verfahren zur Herstellung der erfindungsgemäßen Schreib-/Leseschaltung eingegangen werden.

Zunächst wird ein unterliegendes Substrat entsprechend den Vorgaben n- beziehungsweise p-dotiert. Im Anschluß wird eine Lithographie durchgeführt, und es werden die vorgesehenen Vertiefungen beziehungsweise Gräben zwischen den Vorsprüngen der einzelnen Vertikaltransistoren weggeätzt. Im Anschluß erfolgt ein Dotieren der neugebildeten Oberflächen durch Implantation. Im nächsten Schritt wird der Gate-Bereich der Vertikaltransistoren oxidiert, um eine Oxidschicht zu bilden. Daran an schließt sich die Abscheidung einer PolysiliziumSchicht, welche die gesamte bislang gebildete Struktur abdeckt. Daran anschließend wird eine Lithographie durchgeführt, um die vorgesehenen Gate-Anschlußbereiche (welche beispielsweise in Figur 5 als nach hinten wegragend deutlich gezeigt sind und welche beispielsweise in Figur 2 schraffiert dargestellt sind) umreissen zu können. Eine anisotrope Trockenätzung führt dann schließlich zur Ausbildung der dargestellten Polysiliziumbereiche, bei denen sich die typischen Spacer um die Vorsprünge der Vertikaltransistoren aus dem Substrat heraus ausbilden. Die dadurch entstandene Struktur wird am besten in Figur 3 gezeigt.

Zur Isolation der verschiedenen elektrischen Elemente der so gebildeten Vertikaltransistoren werden alle noch vorhandenen Vertiefungen mit Oxid verfüllt. Nach einem dann notwendigen Planarisierungsschritt, beispielsweise mittels CMP, kann auf der sich dadurch bildenden planaren Oberfläche eine weitere Photolithographie durchgeführt werden, mit deren Hilfe die Kontaktlöcher 83 gebildet werden, welche mit einem Metall, beispielsweise Wolfram, welches aus Wolframfluorid abgeschieden wird, gefüllt werden können.

Nach einer weiteren Planarisierung mittels chemisch-mechanischen Polierens kann dann die erste Metallisierungsebene 80 abgeschieden werden, welche im Anschluß durch ein lithographisches Verfahren und einem Ätzschritt seine Leiterbahnenstruktur erhält. Die weiteren Kontaktlöcher/Oxidschichten und Metallisierungsebenen werden in der gleichen Art und Weise diesen ersten überlagert.

Es ist bezüglich der Metallebenen ebenso möglich, den umgekehrten Weg zu gehen. Hierbei werden nicht zuerst die Metallebenen abgeschieden, sondern Oxidschichten. Diese werden, gegebenenfalls in einem zweistufigen Verfahren mittels Photolithographie und Ätzen so behandelt, daß die Leiterbahnen und Kontaktlochstrukturen im Oxid entstehen. Im folgenden werden die so entstandenen Vertiefungen der Kontaktlöcher und der Leiterbahnen mit einem geeigneten Metall aufgefüllt. Hierbei spricht man von einer Damaszenertechnik.

Die gegenüber konventionell hergestellten und aufgebauten Schreib-/Leseschaltungen notwendigen Zusatzschritte bei der Herstellung von Vertikaltransistoren und beim komplexeren Aufbau der Metallebenen oberhalb der Transistoren führen zu erhöhten Kosten, welche gegen den Zugewinn an Miniaturisierungsgrad abgewogen werden müssen.

## Patentansprüche

1. Integrierte Schreib-/Leseschaltung zur Auswertung von zumindest einer Bitline (BL, BBL) in einem DRAM Speicher,
dadurch gekennzeichnet, daß zumindest ein in der Schreib/Leseschaltung verwendeter Transistor ein Vertikaltransistor ist.

2. Schreib-/Leseschaltung nach Anspruch 1, dadurch gekennzeichnet, daß sie zumindest zwei Transistorpaare (T1/T2, T4/T5) mit Transistoren jeweils gleichen Kanaltyps zur Auswertung aufweist und die für die Transistorpaare (T1/T2, T4/T5) der Schreib-/Leseschaltung verwendeten Transistoren Vertikaltransistoren (T1, T2, T4, T5) sind.

3. Schreib-/Leseschaltung nach Anspruch 2, dadurch gekennzeichnet, daß die Vertikaltransistoren jedes Transistorpaars (T1/T2, T4/T5) einen gemeinsamen Source/Drain Bereich (63) aufweisen.

4. Schreib-/Leseschaltung nach Anspruch 2 oder 3, dadurch gekennzeichnet, daß die zum Aufschalten von Spannungen (VDD, GND) auf die Transistorpaare (T1/T2, T4/T5) verwendeten Transistoren Vertikaltransistoren (T3, T6) sind

5. Schreib-/Leseschaltung Anspruch 4, dadurch gekennzeichnet, daß die Vertikaltransistoren (T1, T2, T4, T5) jedes Transistorpaars (T1/T2, T4/T5) und der zur Aufschaltung der Spannung (VDD; GND) verwendete Vertikaltransistor (T3, T6) einen gemeinsamen Source/Drain-Bereich (63) aufweisen.

6. Schreib-/Leseschaltung nach Anspruch 5, dadurch gekennzeichnet, daß der gemeinsame Source/Drain Bereich (63) der Vertikaltransistoren (T1, T2, T4, T5, T3, T6) mit einer Spannungsquelle (VDD, GND) über eine SET Leitung (17, 27) verbunden ist.

7. Schreib-/Leseschaltung nach einem der Ansprüche 2 bis 6, dadurch gekennzeichnet, daß die für die Transistorpaare (T1/T2, T4/T5) verwendeten Vertikaltransistoren (T1, T2, T4, T5) eine Breite in Querrichtung zu der zumindest einen Bitline (BL, BBL) aufweisen, die in etwa der Rasterbreite entspricht.

8. Schreib-/Leseschaltung nach einem der Ansprüche 1 bis 7, dadurch gekennzeichnet, daß sie eine Multiplexerschaltung (A) zum Schalten der zumindest einen Bitline (BL, BBL) aufweist und die für die Multiplexerschaltung (A) verwendeten Transistoren Vertikaltransistoren (T7, T8) sind.

9. Schreib-/Leseschaltung nach Anspruch 8, dadurch gekennzeichnet, daß zumindest ein Teil der Vertikaltransistoren (T7, T8) der Multiplexerschaltung (A) einen gemeinsamen Polysilizium-Gate-Bereich (65) aufweist..

10. Schreib-/Leseschaltung nach Anspruch 9, dadurch gekennzeichnet, daß der gemeinsame Polysilizium-Gate-Bereich (65) der Vertikaltransistoren (T7, T8) mit einer Multiplexer-Signalquelle (MUX) verbunden ist.

11. Schreib-/Leseschaltung nach einem der Ansprüche 1 bis 10, dadurch gekennzeichnet, daß sie eine Precharge/Equalize-Schaltung (C) aufweist und die für die Precharge/Equalize-Schaltung (C) verwendeten Transistoren Vertikaltransistoren (T9, T10, T11) sind.

12. Schreib-/Leseschaltung nach Anspruch 11, dadurch gekennzeichnet, daß zumindest ein Teil der Vertikaltransistoren (T9, T10, T11) der Precharge/Equalize-Schaltung (C) einen gemeinsamen Polysilizium-Gate-Bereich (71) aufweist.

13. Schreib-/Leseschaltung nach Anspruch 12, dadurch gekennzeichnet, daß der gemeinsame Polysilizium-Gate-Bereich (71) der Vertikaltransistoren mit einer Equalizer-Signalquelle (EQ) verbunden ist.

14. Schreib-/Leseschaltung nach einem der Ansprüche 11 bis 13, dadurch gekennzeichnet, daß die Precharge/Equalize-Schaltung für jede der zumindest einen Bitline einen Transistor (T9, T10) aufweist, welcher an einem Source/Drain Bereich mit einer Spannungsquelle (VBLEQ) verbunden ist und diese Source/Drain-Bereiche einen gemeinsamen Source/Drain-Bereich (74) bilden..

15. Schreib-/Leseschaltung nach einem der Ansprüche 1 bis 14, dadurch gekennzeichnet, daß die Vertikaltransistoren
einen Vorsprung (64a, 70, 77) auf dem Substratmaterial als Kanalbereich,
eine auf dem Vorsprung (64a) angeordnete Schicht (56, 57, 58, 60, 61, 62, 66, 67, 72, 73) aus Material mit einer zum Substrat inversen Dotierung als ersten Source/Drain-Bereich,
eine auf dem Substrat neben dem Vorsprung (64a, 70, 77) angeordnete Schicht (59, 63, 69, 74, 76) aus Material mit einer zum Substrat inversen Dotierung als zweiten Source/Drain-Bereich;
und einen an den Seitenwänden des Vorsprungs (64a, 70, 77) und am Übergang von den Seitenwänden des Vorsprungs (64a, 70, 77) zum zweiten Source/Drain-Bereich angeordneten Polysiliziumbereich (50, 52, 54, 65, 71)
aufweisen.

16. Schreib-/Leseschaltung nach Anspruch 15, dadurch gekennzeichnet, daß der Vorsprung (64a, 70, 77) bei den Transistoren der Transistorpaare (T1/T2, T4/T5) eine solche Breite aufweist, daß er in das Raster einer Bitline hineinpasst.

17. Schreib-/Leseschaltung nach Anspruch 15 oder 16, dadurch gekennzeichnet, daß der Vorsprung (64a, 70, 77) eine solche Breite aufweist, daß er in das Raster einer Bitline ausfüllt.

18. Schreib-/Leseschaltung nach einem der Ansprüche 1 bis 17, dadurch gekennzeichnet, daß die Schreib-/Leseschaltung mit zwei Bitlines (BL, BBL) verbunden ist.

19. Schreib-/Leseschaltung nach Anspruch 18, dadurch gekennzeichnet, daß die zwei Bitlines (BL, BBL) oberhalb der Schreib-/Leseschaltung und bezüglich der Hauptebene des DRAM-Speichers übereinander angeordnet sind.

20. Schreib-/Leseschaltung nach einem der Ansprüche 1 bis 19, dadurch gekennzeichnet, daß die Verbindung der Bitlines mit den Vertikaltransistoren über im wesentlichen vertikale Leiterbahnen (10, 11, 12, 13, 20, 21, 22, 23, 31, 32, 34, 35, 40, 41, 42, 43) erfolgt.

21. Verwendung von Vertikaltransistoren für die Schreib/Leseschaltungen eines integrierten DRAM Speichers.
